# EUROPÄISCHE PATENTSCHRIFT

(11) **EP 0 359 161 B1**
(45) Veröffentlichungstag und Bekanntmachung des Hinweises auf die Patenterteilung: **15.09.1993**
(21) Anmeldenummer: 89116731.4
(22) Anmeldetag: 09.09.1989
(51) Int. Cl.: G05D 23/24, G01K 1/16

(54) **Sensor- und Bedienmodul**
Sensing and control module
Module de mesure et de commande

(30) Priorität: 13.09.1988 DE 8811566 U
(43) Veröffentlichungstag der Anmeldung: 21.03.1990
(73) Patentinhaber: HONEYWELL AG, 63067 Offenbach (DE)
(72) Erfinder: Heinen, Hartwig, D-6454 Bruchköbel (DE); Schindler, Jürgen, D-6080 Gross-Gerau - Wallerstädten (DE)
(74) Vertreter: Herzbach, Dieter, Dipl.-Ing.

(56) Entgegenhaltungen:
- DE-A- 1 779 697
- DE-A- 2 452 514
- FR-A- 2 544 126
- US-A- 4 235 368
- US-A- 4 347 443
- PATENT ABSTRACTS OF JAPAN,vol. 005, no. 173 (P-087),05 November 1981;& JP-A-56 100329

## Beschreibung

Die vorliegende Erfindung bezieht sich auf einen Sensor- und Bedienmodul nach dem Gattungsbegriff des Patentanspruches 1.

Ein derartiger Sensor- und Bedienmodul ist aus Patent Abstracts of Japan, Vol. 005, No. 173, vom 5. November 1981 (JP-A-56 100 429) bekannt. Dort ist in der oberen Hälfte der Frontseite des Moduls ein Bedienungsknopf angeordnet und in der unteren Hälfte ist eine Ausnehmung vorgesehen, in die ein Temperaturfühler eingesetzt ist. Der Temperaturfühler ist in einem nach hinten wärmeabschirmenden Gehäuse angeordnet, so daß er durch die Wärmeentwicklung der in dem Modul angeordneten elektrischen Schaltkreise nicht beeinfluß wird aber durch die Wärme außerhalb des Moduls beeinflußt werden kann.

Ferner zeigt die US-A-43 47 443 einen Raumthermostaten, bei dem durch Luftschlitze eine Abfuhr der durch elektronische Komponenten erzeugten Wärme ermöglicht wird. Ein Temperaturfühler ist durch einen Wärmeschild gegen die Wärmeentwicklung der elektronischen Komponenten abgeschirmt.

Wenn der eingangs erwähnte Modul zur Erfassung des Istwertes der Raumtemperatur verwendet wird, so muß sichergestellt sein, daß der Fühler auch tatsächlich die Raumtemperatur erfaßt und nicht z.B. die Temperatur einer Wand, an der er montiert ist und ferner soll für den Fall, daß von Hand einstellbare Bedienelemente an dem Modul vorgesehen sind, sichergestellt sein, daß durch die Handwärme keine Beeinflussung des Temperaturfühlers erfolgt.

Es ist daher die Aufgabe der vorliegenden Erfindung, einen Sensor- und Bedienmodul der eingangs genannten Art konstruktiv so auszubilden, daß der in ihm enthaltene Temperaturfühler den tatsächlichen Istwert ohne Verfälschung durch Fremdeinflüsse erfaßt. Die Lösung dieser Aufgabe gelingt gemäß den kennzeichnenden Merkmalen des Patentanspruches 1. Weitere vorteilhafte Ausgestaltungen des Moduls gemäß der vorliegenden Erfindung sind den abhängigen Ansprüchen entnehmbar.

Anhand eines in den Figuren der beiliegenden Zeichnung dargestellten Ausführungsbeispieles sei im folgenden der Sensor- und Bedienmodul gemäß der vorliegenden Erfindung näher erläutert. Es zeigen:
- Fig. 1: eine Vorderansicht des Moduls;
- Fig. 2: einen Längsschnitt durch den Modul gemäß Fig. 1;
- Fig. 3: eine aufgebrochene Vorderansicht des Moduls.

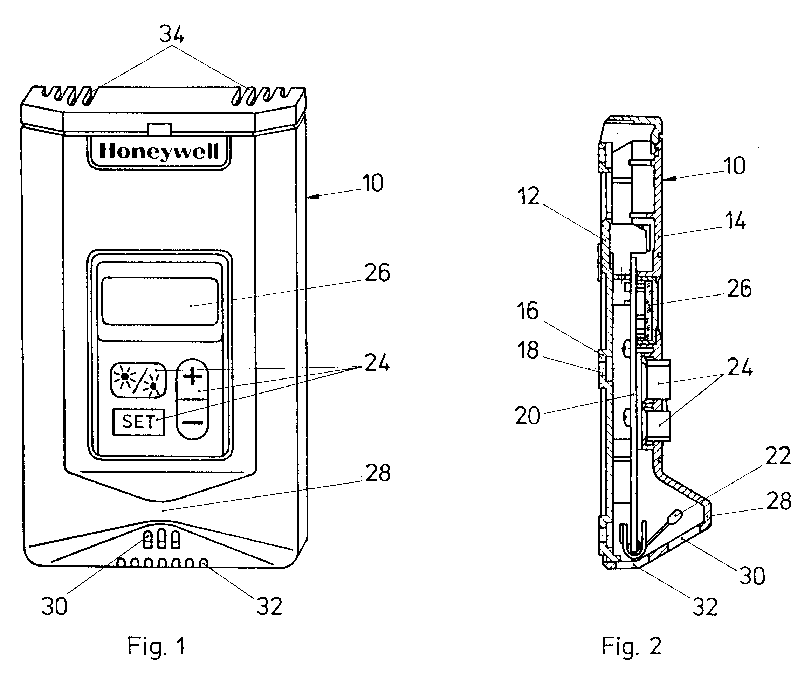

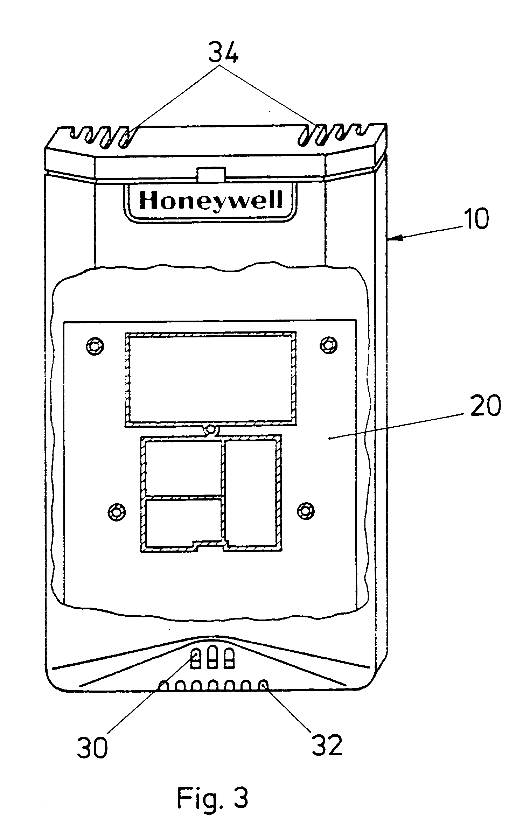

Gemäß den Figuren 1 bis 3 umfaßt ein Sensor- und Bedienmodul 10 ein Gehäuse bestehend aus einer Bodenplatte 12 und einem mit dieser verrastbaren Deckel 14. Die Bodenplatte 12 weist angeformte Augen 16 mit abgesetzten Bohrungen 18 auf, über welche sie mittels nicht-dargestellter Schrauben, z.B. an einer Wand in einem Wohnraum befestigt werden kann.

Eine gedruckte Schaltungsplatine 20 ist mit dem Deckel 14 verbunden und trägt einen Temperaturfühler 22, z.B. in Form eines NTC-Widerstandes, sowie Bedienelemente 24 und eine LCD-Anzeige 26, welche auf der Frontseite des Deckels zugänglich sind.

An dem Deckel 12 ist im unteren Bereich unterhalb der Bedienelemente 24 eine nach vorne springende dachkantförmige Nase 28 angeformt. In dieser Nase 28 sind auf der Unterseite Luft-Eintrittsschlitze 30 und 32 angebracht, durch die die Luft über den Temperaturfühler 22 und seitlich von bzw. hinter der Schaltungsplatine 20 zu Luftaustrittsschlitzen 34 geführt wird, die seitlich an der Oberseite des Deckels 14 angeordnet sind. Die Schaltungsplatine 20 erstreckt sich nur über einen Teil der Gesamtbreite des Gehäuses 12, 14, so daß die über den Temperaturfühler 22 streichende Luft seitlich an der Schaltungsplatine vorbeistreichen und an den Luft-Austrittsschlitzen 34 austreten kann. Die durch die Luft-Eintrittsschlitze 32 eintretende und hinter der Schaltungsplatine 20 nach oben zu den Luft-Austrittsschlitzen 34 strömende Luft erzeugt hierbei eine Kaminwirkung.

Es liegt auf der Hand, daß anstelle der Bedienelemente in Form der Tastatur 24 auch andere Bedienelemente, wie beispielsweise ein Einstellpotentiometer mit einem Drehknopf oberhalb der Nase 28 angeordnet sein können, wobei deren Handbedienung ohne Einfluß auf den in der Nase untergebrachten Temperaturfühler bleibt, da diese Nase nur unterhalb mit Luft-Eintrittsschlitzen versehen ist und oberhalb dem Bedienelement gegenüber abgeschlossen ist.

## Patentansprüche

1. Sensor- und Bedienmodul (10) mit einem Gehäuse (12, 14), das einen Temperaturfühler (22) enthält und an dem ein oder mehrere manuell betätigbare Bedienelemente (24) angeordnet sind, wobei der Fühler in einem von dem Gehäuse nach vorne springenden Teil unterhalb der Bedienelemente im unteren Teil des Gehäuses angeordnet ist, **dadurch gekennzeichnet,** daß der Temperaturfühler (22) in einer an der Gehäuseoberfläche angeformten, dachkantförmig nach vorne springenden Nase (28) angeordnet ist, wobei die Nase (28) auf ihrer Unterseite Luft-Eintrittsschlitze (30, 32) aufweist und auf ihrer dem Bedienelement (24) zugewandten Oberseite geschlossen ist, daß in dem Gehäuse eine den Temperaturfühler (22) tragende Schaltungsplatine (20) angeordnet ist und daß das Gehäuse (12, 14) an seiner Oberseite mit Luft-Austrittsschlitzen (34) versehen ist.

2. Modul nach Anspruch 1, **dadurch gekennzeichnet,** daß die Luft-Eintrittsschlitze (30, 32) in zwei Gruppen angeordnet sind, wobei die eine Gruppe (30) in einer Ebene vor der Ebene der Schaltungsplatine (20) und die andere Gruppe (32) hinter der Ebene der Schaltungsplatine in das Gehäuse mündet.

3. Modul nach Anspruch 2, **dadurch gekennzeichnet,** daß sich die Schaltungsplatine (20) nur über einen Teil der Gehäusebreite erstreckt und die Luft-Austrittsschlitze (34) jeweils seitlich an der Oberseite des Gehäuses (12, 14) angeordnet sind.

## Claims

1. Sensor and control module (10) comprising a housing (12,14), which contains a temperature sensor (22) and which is provided with one or a plurality of manually actuatable control elements (24) whereat the temperature sensor is arranged in a housing portion projecting outwardly from said housing in its lower portion and below of said control elements, **characterized in that,** the temperatur sensor (22) is arranged in a pentaprism-shaped nose (28) formed with and extending from the housing surface, whereat said nose (28) at its lower side comprises air intake slots (30,32) and is closed at its upper side facing said control element (24), that within the housing a circuit board (20) is arranged which supports said temperature sensor (22) and that the housing (12,14) is provided at its upper side with air exit slots (34).

2. Module according to claim 1, **characterized in that** the air intake slots (30,32) are arranged in two sets, whereat one set (30) is arranged in a plane in front of the plane of said circuit board (20) and the other set (32) is arranged in a plane behind the plane of said circuit board.

3. Module according to claim 2, **characterized in that** said circuit board (20) only extends over a portion of an internal width of said housing and that the air exit slots (34) each are arranged laterally at the upper side of said housing (12,14).

## Revendications

1. Module de détection et de commande (10) comportant un boîtier (12, 14) qui renferme une sonde de température (22) et sur lequel sont disposés un ou plusieurs éléments de commande (24) pouvant être actionnés manuellement, la sonde étant disposée dans une partie faisant saillie du boîtier vers l'avant, sous les éléments de commande, dans la partie inférieure du boîtier, caractérisé en ce que la sonde de température (22) est disposée dans un nez (28) formé sur la surface du boîtier et faisant saillie vers l'avant, en forme d'arête de toit, le nez (28) comportant sur son côté inférieur des fentes d'entrée d'air (30, 32), et étant fermé sur son côté supérieur dirigé vers l'élément de commande (24), en ce que dans le boîtier est disposée une plaque de circuit imprimé (20) portant la sonde de température (22), et en ce que le boîtier (12, 14) est pourvu sur sa face supérieure de fentes de sortie d'air (34).

2. Module selon la revendication 1, caractérisé en ce que les fentes d'entrée d'air (30, 32) sont disposées selon deux groupes, l'un des groupes (30) débouchant dans le boîtier dans un plan situé à l'avant du plan de la plaque de circuit imprimé (20), et l'autre groupe (32) débouchant dans le boîtier, à l'arrière du plan de la plaque de circuit imprimé.

3. Module selon la revendication 2, caractérisé en ce que la plaque de circuit imprimé (20) s'étend uniquement sur une partie de la largeur du boîtier, les fentes de sortie d'air (34) étant disposées latéralement de chaque côté de la face supérieure du boîtier (12, 14).
